# EUROPEAN PATENT SPECIFICATION

(11) **EP 1 580 880 B1**
(45) Date of publication and mention of the grant of the patent: **12.10.2016**
(21) Application number: 05102325.7
(22) Date of filing: 23.03.2005
(51) Int. Cl.: H03F 3/62, H03F 1/52, H02H 9/04, H02H 9/06

(54) **Disturbance protection for a telecommunications device**
Störschutz für eine Telekommunikationsvorrichtung
Protection de perturbation pour un dispositif de télécommunication

(30) Priority: 24.03.2004 FI 20045096
(43) Date of publication of application: 28.09.2005
(73) Proprietor: Teleste Oyj, 20660 Littoinen (FI)
(72) Inventor: Rintalaulaja, Mika, 20660 Littoinen (FI); Nurminen, Mikko, 20460 Turku (FI); Ranta, Jouko, 21250 Masku (FI)
(74) Representative: Tampereen Patenttitoimisto Oy

(56) References cited:
- FR-A- 2 576 471
- US-A- 4 887 180
- US-A- 5 390 337

## Description

### BACKGROUND OF THE INVENTION

The invention relates to a disturbance protection system for a telecommunications device, the telecommunications device comprising an input port, an output port and a part to be protected implemented by means of semi-conductor components.

Among telecommunications devices for instance cable television amplifier components are typically protected in such a manner that a gas-discharge tube is arranged at the input and output ports. A gas-discharge tube protects from a surge wave so that a disruptive discharge occurs in the gas-discharge tube starting from a certain voltage level that short circuits most of the energy in the surge wave to the ground. However, the gas-discharge tube is not alone able to protect the cable television amplifier components adequately enough for instance from an electrostatic discharge, in other words from what is known as an ESD pulse. Therefore, a diode limiter has also been used in a cable television amplifier for protecting the components. In order to ensure durability, the diode limiter is positioned as close as possible to the component to be protected, in which case one diode limiter does not necessarily protect several components, but several diode limiters would be required, if all components were to be protected. Problems have also been observed concerning the durability of the diode limiter, and therefore better solutions for protecting cable television amplifier components need to be developed.

Patent publication US4887180 discloses a device for protecting electronic equipment against strong electromagnetic pulses, comprising two series-connected dischargers followed by a filter having a cut-off frequency dependent of the output level of the second discharger.

### BRIEF DESCRIPTION OF THE INVENTION

It is an object of the present invention to provide a new type of disturbance protection for a telecommunications device that is improved in comparison with the prior art.

The disturbance protection according to the invention is characterized in that the disturbance protection system comprises at least three overvoltage protection components provided with different properties, whereby a gas-discharge tube, which is considered as a first overvoltage protection component, is arranged at the output port, and a second overvoltage protection component is provided in the vicinity of the components to be protected, and the disturbance protection system also comprises a third overvoltage protection component.

It is an essential idea of the invention that a gas-discharge tube, which is the first overvoltage protection component, provided at the output port and the second overvoltage protection component in the vicinity of the telecommunications device are arranged to protect the components in a telecommunications device. A third overvoltage protection component is also included in the disturbance protection system. The different overvoltage protection components are provided with different properties. Thus, an extremely good immunity is obtained for the components in the telecommunications device, for instance against surge wave pulses and ESD pulses. A gas-discharge tube offers extremely good protection against a surge wave pulse. The other overvoltage protection components then again protect for instance the amplifier circuit as regards the surge wave pulse thereof that is not filtered by the gas-discharge tube. Furthermore, the second overvoltage protector may provide adequate protection for instance against an ESD pulse and the third overvoltage protector may offer additional protection against an ESD pulse and protect in particular the second overvoltage protector from breakdown.

The idea of an embodiment is that the telecommunications device is a cable television amplifier comprising components for processing a return path signal, whereby the cable television amplifier includes a diplexer that is arranged between the output and/or input port and the forward path components and the return path components, in which case the third overvoltage protector is arranged between the input and/or output port and the diplexer such that the third overvoltage protector is arranged to protect both the return path components and the forward path components. Consequently one overvoltage protector is able to protect the forward path components as well as the second overvoltage protector in connection therewith and the return path components. Typically the return path components endure disturbance pulses fairly well, in which case the third overvoltage protector is enough to protect the return path components from an ESD pulse. The idea of another embodiment is that components are also protected with a high-pass filter in the vicinity of the second overvoltage protector. Then, for instance an amplifier is extremely well protected. In addition, the high-pass filter also protects the second overvoltage protector.

### BRIEF DESCRIPTION OF THE DRAWINGS

The invention will be explained in greater detail in the accompanying drawings, in which
Figure 1 shows a simplified block diagram of a cable television amplifier, and
Figure 2 shows a simplified block diagram of disturbance protection at one RF port.

### BRIEF DESCRIPTION OF THE INVENTION

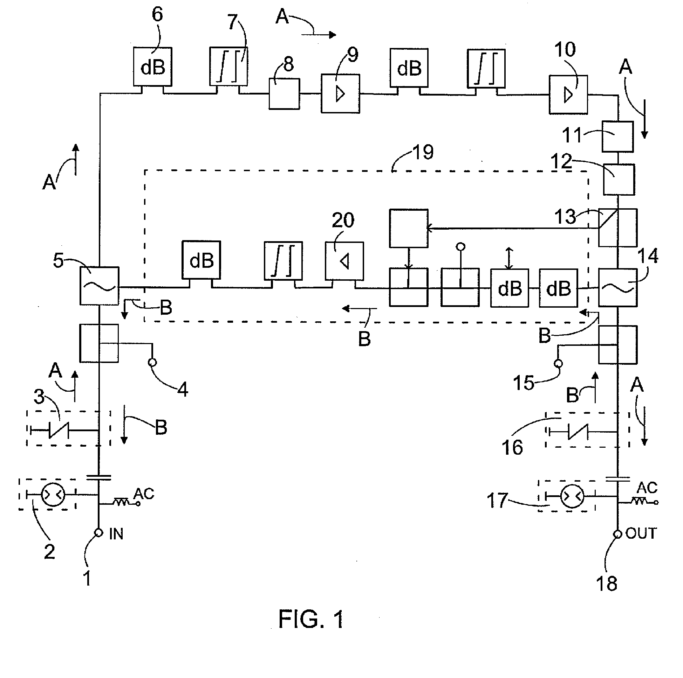

Figure 1 shows a simplified block diagram of a cable television amplifier. In Figure 1 arrows A illustrate the course of a forward path signal and arrows B correspondingly illustrate the course of a return path signal. What is meant by a forward path signal is, for instance, a TV program signal distributed by a service producer such as a cable television company to the customer, or the consumer. A return path signal is in turn, for instance, a signal assigned by the customer, or the consumer, to the service producer.

The cable television amplifier comprises an input port 1, after which an input gas-discharge tube 2 is arranged. An input suppressor 3 is arranged after the input gas-discharge tube 2. In this specification the term "suppressor" refers to bi-directional semiconductor ESD protection, such as product 0603 ESDA Suppressor of the Cooper-Bussman company.

A tap used to form an input test point 4 is provided after the input suppressor 3. The suppressor 3 can also be arranged at the tap. An input diplexer 5 is provided after the input test point 4. The diplexer 5 directs the forward path signal and the return path signal to travel along the routes illustrated by arrows A and B in Figure 1.

Next, an input attenuator 6 and a signal inclination controller 7 are provided on the route of the forward path signal. An input diode limiter 8 is arranged before an input amplifier 9. An output amplifier 10 is arranged after the input amplifier 9 and intermediate control components are in turn provided between the input amplifier 9 and the output amplifier 10, meaning attenuator and inclination control components of corresponding type as those before the input amplifier 9.

An output diode limiter 11 is then arranged in the vicinity of the output amplifier 10 and a filtering component, i.e. a high-pass filter 12, is arranged in the vicinity of the output diode limiter 11.

A directional coupler 13 is arranged after the high-pass filter 12 so as to be able to take a sample for measuring the level of the forward path signal. The sample is also utilized for processing the return path signal. An output diplexer is provided after the directional coupler 13. The output diplexer 14 operates in a similar manner as the input diplexer 5.

A tap is arranged after the output diplexer 14 for an output test point 15. Thereafter an output suppressor 16 is provided. The output suppressor 16 is similar to the input suppressor 3.

An output gas-discharge tube 17 that is similar to the input gas-discharge tube 2 is also provided at the output port 18. The number of RF ports 18 may also be greater than the only one input port 1 and one output port 18 shown in Figure 1.

For processing the return path signal the cable television amplifier is provided with return path components within the area surrounded by a dashed line 19. The return path components include for instance a return path amplifier 20, attenuators and inclination controllers and other components corresponding to those in connection with the forward path components. In this context, the return path components and the function thereof are not explained in more detail, since the components concerned and the function thereof are obvious to those skilled in the art. Furthermore, for clarity, no other components possibly associated with the cable television amplifier are presented in the block diagram.

The gas-discharge tubes 2 and 17 operate in such a manner that a disruptive discharge occurs in the gas composition therein, which may be a composition of for instance neon and argon, starting from a particular voltage level. The disruptive discharge may occur, for instance, starting from about 150 volts. Then the gas-discharge tube short circuits most of the energy in the surge wave pulse to the ground. The diode limiters 8 and 11 are required to protect the forward path input amplifier 9 and the output amplifier 10. These diode limiters protect the amplifiers 9 and 10 as regards the surge wave pulse that the gas-discharge tubes 2 and 17 do not filter. However, the gas-discharge tubes 2 and 17 are capable of protecting the return path components from the surge wave pulses, since bipolar technique is used in the return path components, which is not very sensitive to surge wave pulses.

The electrostatic discharge, in other words what is known as the ESD pulse rise time caused by the ESD, is very small, typically for instance 0.7 to 1 nanoseconds. Consequently the ESD pulse does not cause disruptive discharge in the gas-discharge tubes 2 and 17. Thus, the cable television amplifier should also be provided with protection against ESD pulses. The suppressors 3 and 16 are bi-directional ESD disturbance attenuators. The suppressors 3 and 16 start conducting with voltage ± 125 V and the suppressors restrict the voltage to ± 35 V. What has been observed in tests is that a single suppressor is not adequate enough to protect the forward path amplifiers 9 and 10, but it has been observed that the suppressors 3 and 16 protect the diode limiters 8 and 11 from breakdown. Furthermore, the suppressors 3 and 16 protect the forward path components from ESD pulses, since they are arranged between a diplexer and an RF port, i.e. for instance between the input diplexer 5 and the input port 1 and the output diplexer 14 and the output port 18, in other words at a location where both the forward path signal and the return path signal proceed. The return path components are more insensitive towards the ESD pulses than the forward path components, in which case the suppressors 3 and 16 are adequate to protect them from ESD pulses.

The high-pass filter 12 is a conventional single-stage filter. The angular frequency of the high-pass filter 12 is for instance 20 MHz. Thus, the high-pass filter 12 attenuates the frequencies lower than five megahertz with over 35 decibels. The high-pass filter 12 is required for instance when the return path components are not used, in which case the diplexers 5 and 14 are not used at all and have been passed in their entirety using what is known as a zero dB plug-in unit. Preferably the diplexers 5 and 14 are formed so as to be changed, meaning that they are arranged in position by means of a fast coupling. They can therefore easily be replaced with a zero dB plug-in unit, if the customer does not wish to use the return path. The diplexers 5 and 14 operate to some extent simultaneously as the high-pass filter, and in the absence thereof, lower frequencies, i.e. a higher ESD or surge wave pulse, may proceed to the return path amplifier 9 and 10. The high-pass filter 12 is required especially to protect the output amplifier 10. The high-pass filter is not necessarily required to protect the forward path input amplifier, since amplifier components provided with a fairly good ESD and surge wave pulse duration are typically used as the output amplifier 10.

The diode limiters 8 and 11 protect the input amplifier 9 and the output amplifier 10 from an ESD pulse and a surge wave pulse. The diode limiters 8 and 11 are placed in the immediate vicinity of the amplifier circuit to be protected. What is meant by the immediate vicinity of the amplifier circuit is that the diode limiters are placed as far as possible from the RF ports, in other words at least one other component is arranged between the diode limiter and the RF port. No other components are preferably placed between the amplifier and the diode limiter. The operation of the diode limiters 8 and 11 is so fast that they provide the amplifier with extremely good protection against an ESD pulse. The high-pass filter 12 is also placed as far as possible from the RF port. What is to be avoided in this way is the breakdown of the diode limiter and the high-pass filter by impact of the ESD or surge wave pulse.

In essence, the suppressors 3 and 16 thus enable to protect the return path components from the ESD pulse. The high-pass filter 12 protects the diode limiter 11 and the amplifier circuit irrespective of whether the diplexer is in use or whether it is replaced with what is known as a zero dB plug-in unit. Thus also the amplifier circuits implemented using the new GaAs technique that is more sensitive to disturbance are extremely well protected from ESD and surge wave pulses.

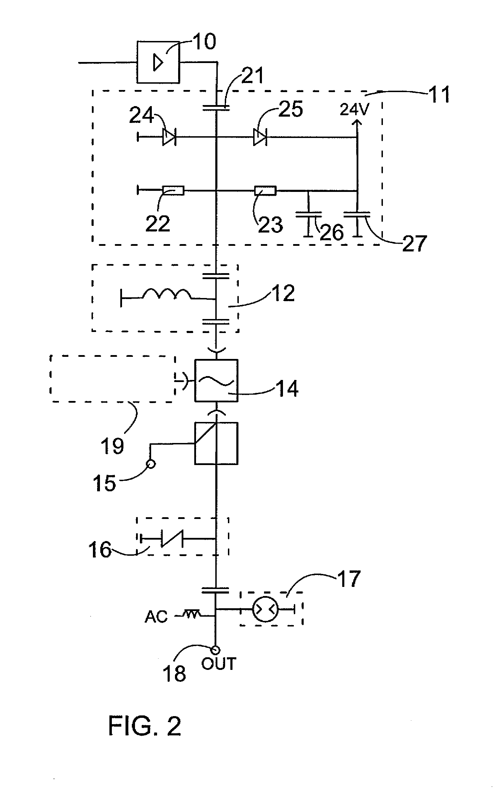

Figure 2 shows a simplified block diagram of the disturbance protection of the output port 18 of the cable television amplifier according to Figure 1. For clarity, the directional coupler 13 is not shown in Figure 2. The high-pass filter 12 and the diode limiter 11 are shown in more detail in Figure 1.

The diode limiter 11 comprises a capacitor 21 functioning as a DC separator. Resistors 22 and 23 are equal in size and are used to carry out the voltage division, by which a 12 V voltage is obtained on the RF line. A first diode 24 is backwardly connected to the ground from an energized RF line, and a second diode 25 is forwardly connected from the RF line to the 24 V voltage. The first diode 24 connected in the back direction starts to conduct with - 12 V and restricts the negative voltage to - 12 V. The second diode 25 connected in the forward direction starts to conduct with + 12 V and restricts the positive voltage to + 12 V. The 12 V backward biasing is necessary since the conduction of diodes is to be avoided using the RF utility signal. Instead of the 24 V operating voltage another available operating voltage can naturally also be used. The operating voltage may therefore also be for instance 12 V. The diode limiter 11 may also include one or more filtering capacitors 26 and 27.

In the above example the first overvoltage protection component is the output gas-discharge tube 17. The second overvoltage protection component is the output diode limiter 11 and the third overvoltage protector component is the output suppressor 16. The properties of these three overvoltage protection components are very different. The operating voltage of the output diode limiter 11 is lower than the operating voltage of the output suppressor 16 and also the operating voltage of the output suppressor 16 is lower than the operating voltage of the output gas-discharge tube 17. Furthermore, the response time of the output suppressor 16 is faster than the response time of the output gas-discharge tube 17. Also, the response time of the output diode limiter 11 is faster than the response time of the output suppressor 16.

Moreover, in Figure 1 the input gas-discharge tube 2 is a fourth overvoltage protector component and the input diode limiter 8 is a fifth overvoltage protection component. The input suppressor 3 is, in turn, correspondingly a sixth overvoltage protection component. Thus, the input diode limiter 8 correspondingly has a lower operating voltage than the input suppressor 3 and the input suppressor 3 has a lower operating voltage than the input gas-discharge tube 2. In addition the input diode limiter 8 has a faster response time than the input suppressor 3 and the input suppressor 3 has a faster response time than the input gas-discharge tube 2.

The drawings and the specification associated therewith are merely intended to illustrate the idea of the invention. The details of the invention may vary within the scope of the claims. Thus, the above disturbance protection is extremely well suitable to be used in connection with co-axial input and output ports. A telecommunications device in which the disturbance protection is arranged may a cable television amplifier provided with an optical input, in which case the above disturbance protection is arranged in connection with the output port. Furthermore the disturbance protection shown above can be applied for protecting other telecommunications devices used in a telecommunications network, such as a switch or a router or similar telecommunications devices.

## Claims

1. A telecommunications device comprising an input port (1), an output port (18) , a part to be protected implemented by means of semi-conductor and a disturbance protection system, **characterized in that** the disturbance protection system comprises at least three overvoltage protection components provided with different properties, whereby a gas-discharge tube (17), which is considered as a first overvoltage protection component, is arranged at the output port (18), and a second overvoltage protection component (11) is provided in the vicinity of the components to be protected (10), and the disturbance protection system also comprises a third overvoltage protection component, that the third overvoltage protection component (16) is arranged between the first overvoltage protection component and the second overvoltage protection component and the second overvoltage protection component has a lower operating voltage than the third overvoltage protection component and the third overvoltage protection component has a lower operating voltage than the first overvoltage protection component and that the second overvoltage protection component has a faster response time than the third overvoltage protection component and the third overvoltage protection component has a faster response time than the first overvoltage protection component.

2. A telecommunications device as claimed in claim 1, **characterized in that** the disturbance protection system also includes a high-pass filter (12) for protecting the second overvoltage protection component.

3. A telecommunications device as claimed in claim 1 or 2, **characterized in that** the telecommunications device is a cable television amplifier.

4. A telecommunications device as claimed in claim 3, **characterized in that** the cable television amplifier comprises components for processing forward path signals, components for processing return path signals and diplexers (5, 14) for conducting the forward path signals and the return path signals, and that the third overvoltage protection component is arranged between the input port (1) and/or the output port (18) and the diplexers (5, 14), whereby the third overvoltage protection component is arranged to protect both the return path components and the forward path components.

5. A telecommunications device as claimed in any one of the preceding claims, **characterized in that** the second overvoltage protection component is a diode limiter (11) and the third overvoltage protection component is a suppressor (16).

6. A telecommunications device as claimed in any one of the preceding claims, **characterized in that** a gas-discharge tube (2) is provided at the input port (1) of the telecommunications device, and said gas-discharge tube is a fourth overvoltage protection component, and that a fifth overvoltage protection component is provided in the vicinity of the components to be protected and that a sixth overvoltage protection component is provided between the fourth overvoltage protection component and the fifth overvoltage protection component.

7. A telecommunications device as claimed in claim 6, **char-acterized** in that the operating voltage of the fifth overvoltage protection component is lower than the operating voltage of the sixth overvoltage protection component, and the operating voltage of the sixth overvoltage protection component is lower than the operating voltage of the fourth overvoltage protection component.

8. A telecommunications device as claimed in claim 6 or 7, **characterized in that** the high-pass filter (12) is arranged to protect the second overvoltage protection component, but no high-pass filter is provided at the input port (1).

## Patentansprüche

1. Telekommunikationsvorrichtung umfassend einen Eingangsanschluss (1), einen Ausgangsanschluss (18), ein mittels eines Halbleiters implementiertes zu schützendes Teil und ein Störschutzsystem, **dadurch gekennzeichnet, dass** das Störschutzsystem mindestens drei mit verschiedenen Eigenschaften versehene Überspannungsschutzbauteile umfasst, wobei eine Gasentladungsröhre (17), welche als erstes Überspannungsschutzbauteil gilt, am Ausgangsanschluss (18) angeordnet ist und ein zweites Überspannungsschutzbauteil (11) in der Nähe der zu schützenden Bauteile (10) vorgesehen ist und das Störschutzsystem auch ein drittes Überspannungsschutzbauteil umfasst, dass das dritte Überspannungsschutzbauteil (16) zwischen dem ersten Überspannungsschutzbauteil und dem zweiten Überspannungsschutzbauteil angeordnet ist und das zweite Überspannungsschutzbauteil eine niedrigere Betriebsspannung als das dritte Überspannungsschutzbauteil aufweist und das dritte Überspannungsschutzbauteil eine niedrigere Betriebsspannung als das erste Überspannungsschutzbauteil aufweist und dass das zweite Überspannungsschutzbauteil eine schnellere Ansprechzeit als das dritte Überspannungsschutzbauteil aufweist und das dritte Überspannungsschutzbauteil eine schnellere Ansprechzeit als das erste Überspannungsschutzbauteil aufweist.

2. Telekommunikationsvorrichtung nach Anspruch 1, **dadurch gekennzeichnet, dass** das Störschutzsystem auch ein Hochpassfilter (12) zum Schutz des zweiten Überspannungsschutzbauteils umfasst.

3. Telekommunikationsvorrichtung nach Anspruch 1 oder 2, **dadurch gekennzeichnet, dass** die Telekommunikationsvorrichtung ein Kabelfernsehverstärker ist.

4. Telekommunikationsvorrichtung nach Anspruch 3, **dadurch gekennzeichnet, dass** der Kabelfernsehverstärker Bauteile zur Verarbeitung von Vorwärtswegsignalen, Bauteile zur Verarbeitung von Rückwegsignalen und Diplexer (5, 14) zum Leiten der Vorwärtswegsignale und der Rückwegsignale umfasst und dass das dritte Überspannungsschutzbauteil zwischen dem Eingangsanschluss (1) und/oder dem Ausgangsanschluss (18) und den Diplexern (5, 14) angeordnet ist, wobei das dritte Überspannungsschutzbauteil derart angeordnet ist, dass es sowohl die Rückwegbauteile als auch die Vorwärtswegbauteile schützt.

5. Telekommunikationsvorrichtung nach irgendeinem der vorangehenden Ansprüche, **dadurch gekennzeichnet, dass** das zweite Überspannungsschutzbauteil ein Diodenbegrenzer (11) ist und das dritte Überspannungsschutzbauteil ein Entstörer (16) ist.

6. Telekommunikationsvorrichtung nach irgendeinem der vorangehenden Ansprüche, **dadurch gekennzeichnet, dass** eine Gasentladungsröhre (2) am Eingangsanschluss (1) der Telekommunikationsvorrichtung vorgesehen ist und die Gasentladungsröhre ein viertes Überspannungsschutzbauteil ist und dass ein fünftes Überspannungsschutzbauteil in der Nähe der zu schützenden Bauteile vorgesehen ist und dass ein sechstes Überspannungsschutzbauteil zwischen dem vierten Überspannungsschutzbauteil und dem fünften Überspannungsschutzbauteil vorgesehen ist.

7. Telekommunikationsvorrichtung nach Anspruch 6, **dadurch gekennzeichnet, dass** die Betriebsspannung des fünften Überspannungsschutzbauteils niedriger als die Betriebsspannung des sechsten Überspannungsschutzbauteils ist und die Betriebsspannung des sechsten Überspannungsschutzbauteils niedriger als die Betriebsspannung des vierten Überspannungsschutzbauteils ist.

8. Telekommunikationsvorrichtung nach Anspruch 6 oder 7, **dadurch gekennzeichnet, dass** das Hochpassfilter (12) derart angeordnet ist, dass es das zweite Überspannungsschutzbauteil schützt, aber kein Hochpassfilter am Eingangsanschluss (1) vorgesehen ist.

## Revendications

1. Dispositif de télécommunications comprenant un port (1) d'entrée, un port (18) de sortie, une partie à protéger mise en oeuvre par un moyen de semi-conducteur et un système de protection contre les perturbations, **caractérisé en ce que** le système de protection contre les perturbations comprend au moins trois composants de protection contre les surtensions dotés de propriétés différentes, ainsi un tube (17) à décharge de gaz, qui est considéré comme un premier composant de protection contre les surtensions, est disposé au niveau du port (18) de sortie, et un deuxième composant (11) de protection contre les surtensions est prévu à proximité des composants à protéger (10), et le système de protection contre les perturbations comprend également un troisième composant de protection contre les surtensions, **en ce que** le troisième composant (16) de protection contre les surtensions est disposé entre le premier composant de protection contre les surtensions et le deuxième composant de protection contre les surtensions, et le deuxième composant de protection contre les surtensions a une tension de fonctionnement plus faible que le troisième composant de protection contre les surtensions, et le troisième composant de protection contre les surtensions a une tension de fonctionnement plus faible que le premier composant de protection contre les surtensions, et **en ce que** le deuxième composant de protection contre les surtensions a un temps de réponse plus rapide que le troisième composant de protection contre les surtensions, et le troisième composant de protection contre les surtensions a un temps de réponse plus rapide que le premier composant de protection contre les surtensions.

2. Dispositif de télécommunications selon la revendication 1, **caractérisé en ce que** le système de protection contre les perturbations comprend également un filtre (12) passe-haut permettant de protéger le deuxième composant de protection contre les surtensions.

3. Dispositif de télécommunications selon la revendication 1 ou 2, **caractérisé en ce que** le dispositif de télécommunications est un amplificateur de télévision par câble.

4. Dispositif de télécommunications selon la revendication 3, **caractérisé en ce que** l'amplificateur de télévision par câble comprend des composants permettant de traiter des signaux de trajet vers l'avant, des composants permettant de traiter des signaux de trajet de retour et des diplexeurs (5, 14) permettant de mener les signaux de trajet vers l'avant et les signaux de trajet de retour, et **en ce que** le troisième composant de protection contre les surtensions est disposé entre le port (1) d'entrée et/ou le port (18) de sortie et les diplexeurs (5, 14), ainsi le troisième composant de protection contre les surtensions est disposé pour protéger à la fois les composants de trajet de retour et les composants de trajet vers l'avant.

5. Dispositif de télécommunications selon l'une quelconque des revendications précédentes, **caractérisé en ce que** le deuxième composant de protection contre les surtensions est un limiteur (11) à diode et le troisième composant de protection contre les surtensions est un suppresseur (16).

6. Dispositif de télécommunications selon l'une quelconque des revendications précédentes, **caractérisé en ce qu'un** tube (2) à décharge de gaz est prévu au niveau du port (1) d'entrée du dispositif de télécommunications, et ledit tube à décharge de gaz est un quatrième composant de protection contre les surtensions, et **en ce qu'**un cinquième composant de protection contre les surtensions est prévu à proximité des composants à protéger, et **en ce qu'**un sixième composant de protection contre les surtensions est prévu entre le quatrième composant de protection contre les surtensions et le cinquième composant de protection contre les surtensions.

7. Dispositif de télécommunications selon la revendication 6, **caractérisé en ce que** la tension de fonctionnement du cinquième composant de protection contre les surtensions est plus faible que la tension de fonctionnement du sixième composant de protection contre les surtensions, et la tension de fonctionnement du sixième composant de protection contre les surtensions est plus faible que la tension de fonctionnement du quatrième composant de protection contre les surtensions.

8. Dispositif de télécommunications selon la revendication 6 ou 7, **caractérisé en ce que** le filtre (12) passe-haut est disposé pour protéger le deuxième composant de protection contre les surtensions, mais aucun filtre passe-haut n'est fourni au niveau du port (1) d'entrée.
